# FASCICULE DE BREVET EUROPEEN

(11) **EP 0 703 584 B1**
(45) Date de publication et mention de la délivrance du brevet: **22.04.1998**
(21) Numéro de dépôt: 95402054.1
(22) Date de dépôt: 11.09.1995
(51) Int. Cl.: G11C 8/00

(54) **Procédé de décodage d'addresse dans une mémoire en circuit intégré et circuit mémoire mettant en oeuvre le procédé**
Adressen-Dekodierverfahren für einen integrierten Speicher und Speicherschaltung zur Anwendung eines solchen Verfahrens
Address decoding method for an integrated memory circuit and memory circuit using such a method

(30) Priorité: 12.09.1994 FR 9410833
(43) Date de publication de la demande: 27.03.1996
(73) Titulaire: SGS-THOMSON MICROELECTRONICS S.A., 94250 Gentilly (FR)
(72) Inventeur: Devin, Jean, F-94230 Cachan (FR)
(74) Mandataire: Schmidt, Christian

(56) Documents cités:
- EP-A- 0 030 118
- EP-A- 0 105 757
- EP-A- 0 306 392
- EP-A- 0 558 079
- US-A- 5 029 135
- PATENT ABSTRACTS OF JAPAN vol. 2 no. 149 (E-78) ,13 Décembre 1978 & JP-A-53 117342 (NIPPON DENKI) 13 Octobre 1978,

## Description

L'invention concerne un procédé de décodage d'adresse dans une mémoire en circuit intégré, et une mémoire correspondante.

La tendance actuelle en matière de circuit intégré, en plus de la recherche d'une toujours plus haute densité d'intégration, est la baisse des tensions et puissances nécessaires. Grâce aux innovations technologiques notamment dans le domaine des mémoires, on assiste à une évolution rapide et des circuits mémoire basse tension de l'ordre de 3 volts sont déjà proposés.

Cependant, pour maintenir les performances de vitesse et la fiabilité de ces circuits basse-tension, il est notamment nécessaire de recourir à un circuit multiplieur de tension pour appliquer une tension de lecture suffisante sur les rangées de cellules mémoire, qui rappelons-le, commandent les grilles des cellules, de manière à ce que les cellules passantes appellent suffisamment de courant sur les colonnes (qui connectent les drains), et que leur état passant puissent ainsi rapidement et sûrement être détecté en sortie par les circuits de lecture (reliés aux colonnes).

On utilise par exemple, pour ces multiplieurs de tension, des structures de pompes de charge bien connues de l'homme du métier. Le principe général de ces pompes est de charger des capacités en parallèle et de les décharger en série, en utilisant des réseaux d'interrupteurs à diodes ou transistors commandés par des horloges. On pourra se reporter au brevet US 4,839,787. Un multiplieur de tension est notamment caractérisé par son nombre de transistors et de capacités, sa résistance interne et son aptitude à délivrer un courant donné pendant un temps donné et à une tension de sortie aussi constante que possible : en d'autres termes, pour une charge de sortie donnée, le temps donné au bout duquel la tension de sortie va commencer à s'écrouler. Cette dernière caractéristique est particulièrement sensible, gênant l'utilisation des multiplieurs dans des circuits à forte consommation de courant, à moins d'utiliser une structure coûteuse en surface et très consommatrice en courant (nombre et caractéristiques des transistors et capacités).

Les circuits mémoire asynchrones, c'est à dire ne recevant pas de signal d'horloge externe, peuvent recevoir des données tout le temps : ces données sont immédiatement prises en compte et les opérations correspondantes effectuées. En particulier, les adresses qui se présentent sont immédiatement décodées : le temps d'accès de ces mémoires est ainsi très performant. S'agissant des mémoires asynchrones basse tension, elles sont donc capables de prendre en compte une nouvelle adresse très rapidement : les rangées et colonnes correspondantes de la mémoire sont sélectionnées et les tensions de commande appliquées. En particulier, en lecture, qui est généralement le mode d'accès par défaut, la tension de lecture fournie par le multiplieur est appliquée sur la rangée adressée. Quand ensuite le circuit reçoit l'ordre de fournir le résultat (activation du signal d'autorisation de sortie, communément noté OE, pour "*Output Enable*" en littérature anglo-saxonne), il n'y a plus qu'à activer les circuits de sortie de lecture et le résultat est alors rapidement disponible sur le bus externe de données.

Or les adresses mémoire sont fournies par un bus externe qui peut être bruité (parasites) ou partagé avec d'autres circuits intégrés. Si le décodeur de la mémoire prend en compte tous les changements d'adresses sur le bus externe, on sélectionne à des rythmes très rapprochés des rangées différentes (qui sont des lignes capacitives) auxquelles la tension issue du multiplieur est successivement appliquée : le multiplieur n'a plus le temps nécessaire pour se recharger entre deux sélections de rangée et s'écroule : la tension en sortie du multiplieur diminue dangereusement vers zéro avant de remonter progressivement, le temps de recharge du multiplieur étant particulièrement long, de l'ordre de la centaine de nanosecondes.

Si on reçoit l'ordre de fournir le résultat en sortie (OE) pour une adresse sélectionnée en lecture au moment où le multiplieur est déchargé, la lecture n'est pas significative, ce qui pose en pratique un problème de fiabilité.

L'invention se propose de résoudre ce problème d'écroulement de la tension de lecture des rangées incompatible avec le temps d'accès de la mémoire.

Telle qu'elle est revendiquée dans la revendication 1, l'invention concerne un procédé de décodage des adresses d'une mémoire. On connaît du document EP 0 105 757 un circuit qui isole le décodeur d'adresse pendant une durée déterminée T à chaque détection de changement d'adresse. De cette manière on réduit la consommation de courant.

Selon JP-A-53 117 342, à chaque changement d'adresse, on précharge les lignes de mot à zéro volt pendant une durée prédéterminée après laquelle une ligne de mot est sélectionnée par un décodeur de rangées.

Selon l'invention, à chaque changement d'adresse détecté sur le bus d'adresse, une commande d'inhibition est générée pendant une durée d1 appliquée au circuit de commutation de tension. Ainsi, si on a des changements d'adresse qui se succèdent à un rythme trop important, ces changements seront ignorés, pour ne retenir que le dernier changement, l'inhibition du décodeur allant jusqu'à la durée d1 après le dernier changement d'adresse. Par contre, le décodeur pourra traiter toute adresse stable sur le bus d'adresse pendant une durée supérieure à d1.

L'invention concerne aussi une mémoire en circuit intégré comprenant un décodeur d'adresse pour sélectionner des cellules mémoire, selon la revendication 2. Selon l'invention, la mémoire comprend un circuit de filtrage des changements d'adresse pour inhiber ledit décodeur d'adresse pendant une durée déterminée d1 après détection d'un changement d'adresse.

Plus particulièrement, pour une mémoire organisée matriciellement en rangées et colonnes, l'invention s'applique au filtrage des adresses de rangées de la mémoire. Selon l'invention, le décodeur comprenant un décodeur de rangées et un décodeur de colonnes, le circuit de filtrage émet un signal de filtrage appliqué au décodeur de rangées.

Le décodeur de rangée comprend un circuit de décodage d'adresse pour sélectionner une rangée et désélectionner les autres, et un circuit de commutation de tension sur les rangées, il comprend en outre un circuit d'inhibition qui reçoit en entrée le signal de filtrage, pour inhiber le circuit de commutation de tension. Ainsi, le décodage de l'adresse est effectué en permanence, seule la commutation de la tension de lecture sur la rangée est inhibée. De cette manière, le temps d'accès à la mémoire est pratiquement inchangé, le décodage de l'adresse étant plus lent que la commutation de tension sur les rangées. On choisit la durée d'inhibition de l'ordre de la durée maximale nécessaire au décodage de l'adresse (pire cas).

Pour le circuit de filtrage, on utilise un circuit de détection d'adresse et un circuit de génération d'une impulsion de durée déterminée sur réception d'une impulsion en entrée. Des circuits de détection de transition d'adresse ou de transition sur des signaux de commande ou de validation du circuit sont classiquement utilisés dans les circuits asynchrones, pour générer les horloges internes nécessaires au séquencement des opérations à exécuter. Inversement, quand il n'y a pas de transition d'adresse, ils servent à générer un signal de mise en veille du circuit, permettant une consommation très réduite du circuit. Le principe de fonctionnement d'un circuit de détection d'adresse est de comparer l'état actuel d'un signal d'entrée à l'état précédemment mémorisé, pour mémoriser l'état actuel si il est différent de l'état précédent mémorisé et générer une impulsion de sortie.

Des circuits de génération d'impulsions sont aussi utilisés dans ces mêmes circuits asynchrones, en sortie du circuit de détection de transition d'adresse, pour générer les horloges internes.

D'autres caractéristiques et avantages apparaîtront dans la description détaillée qui suit, faite à titre indicatif et non limitatif de l'invention et en référence aux dessins annexés, dans lesquels :
- la figure 1 est un schéma-bloc d'une mémoire comprenant un circuit de filtrage selon l'invention,
- la figure 2 représente un exemple de réalisation d'un circuit de filtrage selon l'invention,
- la figure 3 est un chronogramme du circuit de filtrage de la figure 2 et
- la figure 4 est une architecture détaillée d'une mémoire selon un mode de réalisation de l'invention.

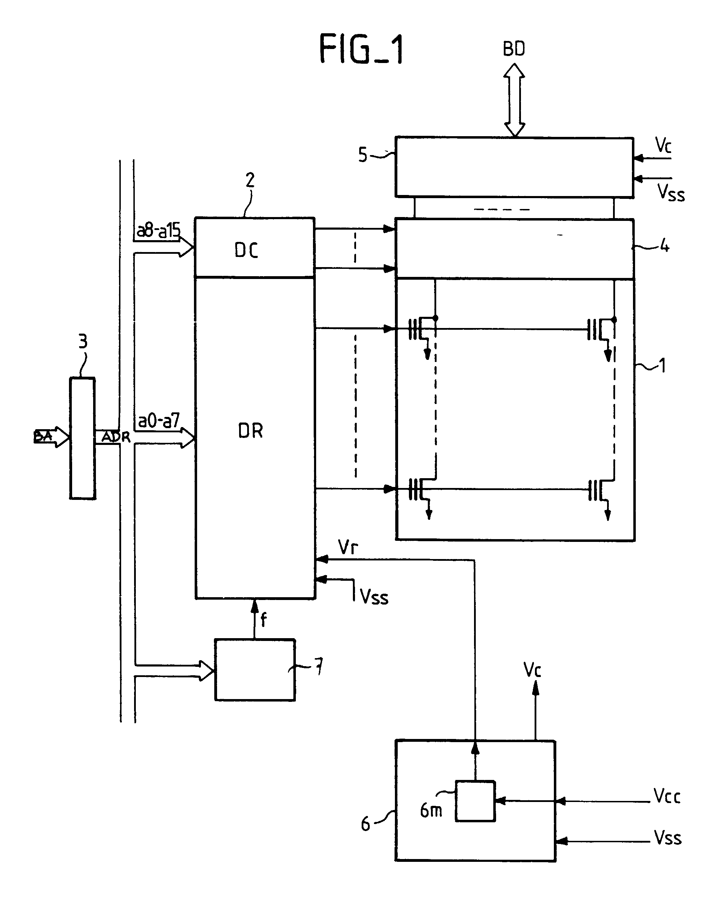

Une architecture générale et simplifiée d'une mémoire en circuit intégré est représentée sur la figure 1. Le plan mémoire matriciel 1 est constitué de colonnes reliées aux drains des cellules et de rangées reliées aux grilles des cellules. Les cellules sont réalisées dans l'exemple en technologie MOS à grille flottante. Mais l'invention ne se limite pas à cet exemple.

Les cellules aux intersections des colonnes et des rangées sont adressées par une adresse de colonne et une adresse de rangée. Un décodeur 2 comprend ainsi un décodeur de rangées DR et un décodeur de colonnes DC. Une adresse présentée par un bus d'adresse externe BA est mémorisée dans un registre d'adresse 3 connecté en sortie au bus d'adresse de la mémoire, noté ADR. Dans l'exemple, le bus d'adresse interne ADR se divise en deux parties : adresse de rangée appliquée en entrée sur le décodeur de rangée DR et adresse de colonne appliquée en entrée sur le décodeur de colonnes DC, codées dans l'exemple respectivement sur les bits d'adresse a0-a7 et a8-a15.

Le décodeur de rangée commande directement les rangées de la mémoire : il applique une tension de commande Vr sur la rangée adressée, et met les autres rangées à la masse (Vss). La tension de commande peut être une tension de lecture ou d'écriture.

Le décodeur de colonne commande un circuit porte 4 qui applique la tension de commande (Vc) à la ou les colonnes adressées et la masse (Vss) aux autres et connecte les colonnes aux circuits d'entrée ou de sortie de données, regroupés sous la référence 5 et connectés au bus externe d'entrée/sortie de données BD de la mémoire.

Les tensions de commande des colonnes et rangées sont par exemple issue d'un circuit 6 de génération de tensions, recevant en entrée les tensions Vcc et Vss. Il comprend notamment un circuit multiplieur 6m recevant en entrée la basse tension de fonctionnement Vcc, par exemple de l'ordre de 3 volts et qui fournit une tension de lecture de l'ordre de 5 volts pour la tension Vr de commande des rangées.

Selon l'invention, l'architecture mémoire comprend en outre un circuit 7 de filtrage des adresses. Ce circuit est connecté en entrée au bus d'adresse interne ADR et délivre en sortie un signal de filtrage f appliqué en entrée au décodeur 2 de la mémoire.

Selon l'invention, ce circuit de filtrage permet de filtrer les transitions d'adresse trop rapides, en inhibant le décodeur 2 pendant une durée d1 après la détection de tout changement d'adresse sur le bus d'adresse interne ADR.

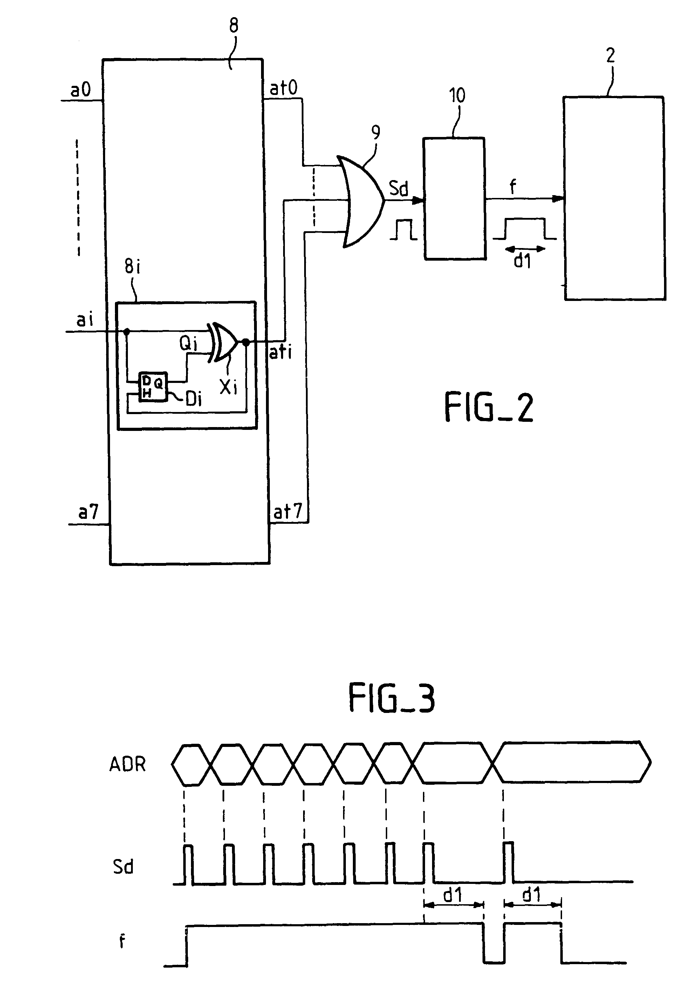

Dans un exemple de réalisation du circuit de filtrage représenté à la figure 2, ce circuit 7 comprend ainsi un circuit 8 de détection d'une transition sur chacun des bits d'adresse, un circuit porte OU logique 9 pour délivrer une information de changement d'adresse dès qu'au moins une transition sur un bit d'adresse est détectée et un circuit 10 générateur d'une impulsion de durée d1 sur le signal de filtrage f.

Plus particulièrement, dans l'exemple représenté, le circuit 8 de détection de transition d'adresse comprend un étage de détection par bit d'adresse à prendre en compte : chaque étage 8i reçoit en entrée un bit d'adresse noté ai et délivre un signal de détection correspondant en sortie noté ati. Un étage 8i comprend par exemple une bascule Di et une porte OU exclusif Xi. L'entrée D de la bascule reçoit le bit d'adresse ai et la sortie Q de la bascule délivre un signal Qi. La porte OU exclusif Xi reçoit sur une entrée le bit d'adresse ai et sur une autre entrée, le signal Qi. La sortie de la porte OU exclusif délivre le signal de détection ati et ce signal est rebouclé sur l'entrée horloge (H) de la bascule.

Le principe de fonctionnement est simple. Pour détecter une transition d'adresse, il y a lieu de mémoriser l'état logique haut ou bas précédent, ce que permet la bascule Di qui mémorise l'état précédent sur sa sortie Q. L'état du signal Qi correspondant est comparé en permanence dans la porte OU exclusif à l'état courant du bit d'adresse ai. La sortie ati de la porte Xi est à un premier niveau logique (0, dans l'exemple) tant que les signaux ai et Qi ont le même niveau logique. Dès que les signaux ai et Qi ont des états logiques différents, la sortie de la porte Xi passe à un deuxième niveau logique (1 dans l'exemple). le passage du premier niveau (0) au deuxième niveau (1) qui correspond à la détection d'une transition sur le bit d'adresse ai provoque la mémorisation de l'état courant du bit ai qui est appliqué sur l'entrée D de la bascule. Les signaux ai et Qi ont alors à nouveau le même état logique et la sortie de la porte Xi repasse au premier niveau logique (0). La détection d'une transition d'adresse sur le bit ai génère donc une impulsion très courte sur la sortie ati.

Les signaux de détection de transition d'adresse ati sont appliqués en entrée du circuit porte OU 9, pour délivrer en sortie un signal Sd de détection de changement d'adresse correspondant à une transition sur au moins un bit d'adresse. Ce signal Sd est appliqué au circuit 10 de génération d'une impulsion, qui génère une impulsion de durée déterminée d1 en réponse à l'impulsion de détection de changement d'adresse. Dans un exemple simple (non détaillé sur les figures), un circuit de génération d'une impulsion peut comprendre un inverseur de commande de charge et décharge d'un condensateur et un circuit de remise en forme du signal fourni par le condensateur. D'autres réalisations plus complexes sont possibles. Ces circuits couramment utilisés sont bien connus de l'homme de métier.

Selon l'invention, l'impulsion de durée déterminée d1 émise sur le signal f de filtrage inhibe le décodeur 2 pendant cette durée. En pratique, seules sont donc décodées les adresses présentes sur le bus d'adresse ADR pendant au moins cette durée d1.

Le chronogramme représenté en figure 3 illustre le fonctionnement du circuit de filtrage. A chaque transition d'adresse sur le bus d'adresse ADR une impulsion de détection de changement d'adresse est émise en sortie Sd de la porte OU. Dans l'exemple, on a représenté 6 changements d'adresse se succédant très rapidement, suivis de deux changements d'adresse se succédant plus lentement, ces deux dernières adresses restant stables pendant une durée supérieure à d1.

Le signal de filtrage f correspondant comporte donc une première impulsion longue, qui débute sur la première impulsion de détection d'adresse et s'arrête après la dernière durée d1 commandée par la septième impulsion de détection de changement d'adresse. Puis une autre impulsion est émise de durée d1, sur la détection du changement d'adresse suivant, l'adresse restant stable ensuite.

Selon l'invention, on s'intéresse surtout aux adresses de rangée de la mémoire : le signal de filtrage sera donc plus particulièrement appliqué selon l'invention au décodeur de rangées DR. Dans ce cas, le circuit de filtrage ne reçoit de préférence que les bits d'adresse de rangées, a0-a7 dans l'exemple (figure 2).

Par ailleurs, on a vu que le décodeur effectue d'une part le décodage d'adresse de rangée pour sélectionner la rangée correspondante et d'autre part commande l'application des tensions nécessaires sur les rangées : tension de commande Vr sur la rangée sélectionnée et tension nulle (Vss) sur les autres rangées, dont on va dire qu'elles sont elles, désélectionnées. Le décodeur comprend donc un circuit de décodage pur et un circuit de commutation de tension.

Selon l'invention, le signal de filtrage est alors avantageusement utilisé (dans un circuit d'inhibition) pour inhiber le circuit de commutation de tension du décodeur de rangée : ainsi le décodage d'adresse est effectué en permanence, en parallèle de la détection de changement d'adresse et seule la commutation des tensions est inhibée par le signal de filtrage. Si entre-temps, la sélection de la rangée disparaît, les tensions ne seront pas appliquées.

De préférence, on ne filtre que la commande de commutation de la tension Vr sur la rangée sélectionnée. En effet, quand une rangée est désélectionnée, c'est la tension nulle qui lui est appliquée, ce qui ne pose pas de problème d'écroulement de la tension générée par le multiplieur 6m. De plus, la commutation de la tension nulle (Vss), dans le cas où la ligne était auparavant sélectionnée ( à Vr), est plus lente que la commutation de la tension Vr. En ne retardant que la sélection et non la désélection, on améliore le temps d'accès d'une mémoire avec filtrage des adresses selon l'invention.

Selon l'invention, le décodeur de rangée comprend ainsi avantageusement pour chaque rangée un circuit d'inhibition recevant en entrée le signal de filtrage f et un signal de commande de sélection de rangée, et délivrant en sortie un signal filtré de commande de sélection de rangée appliqué à un circuit de commutation de tension (Vr) sur la rangée sélectionnée.

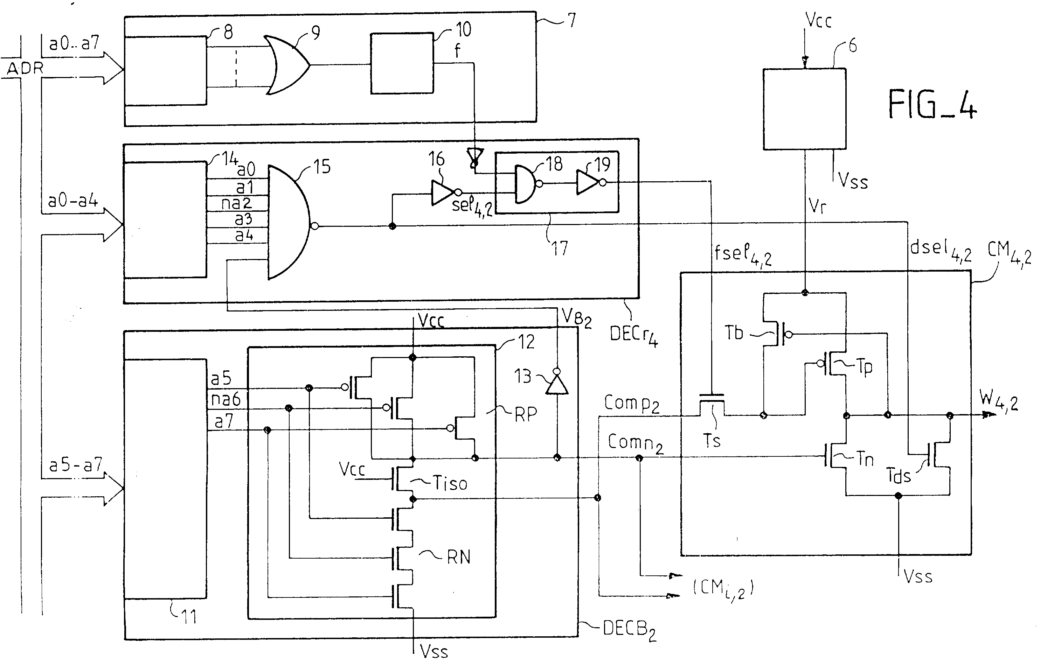

Un exemple de mise en oeuvre préférée du procédé de filtrage selon l'invention va maintenant être expliqué, en référence à la figure 4.

Il correspond à une mémoire comprenant 512 rangées d'adresse 0 à 511, organisées pour le décodage en k=16 blocs de i=32 rangées. Il faut 8 bits d'adresse pour adresser une rangée, notés a0-a7. L'adresse du bloc est codée sur 4 bits, a5-a7, l'adresse de rangée est codée sur 5 bits, a0-a4.

Ainsi, dans un exemple simple de réalisation, le décodeur de rangée comprend k décodeurs d'adresse de blocs délivrant des signaux de validation de bloc. Pour chaque décodeur d'adresse de bloc, on a 32 décodeurs d'adresse de rangée. Chaque décodeur d'adresse de rangée délivre un signal de commande de sélection et un signal de commande de désélection de la rangée correspondante.

Le décodeur de rangée comprend aussi, associés à chaque bloc, 32 circuits de commutation de tension sur une rangée. Chaque circuit est validé par les signaux de sortie du décodeur d'adresse du bloc associé et reçoit en entrée le signal de commande de sélection et le signal de commande de désélection du décodeur d'adresse de la rangée à laquelle il est connecté en sortie et sur laquelle il commute la tension Vr fournie par le circuit de génération de tension 6 (sélection) ou la tension Vss (désélection).

Ainsi, sur la figure 4, on a représenté :
- un décodeur DECB₂ du bloc d'adresse 2
- un décodeur DECr₄ de la rangée d'adresse 4 du bloc B₂ et
- un circuit CM_{4,2} de commutation de tension sur la rangée d'adresse 4 du bloc B₂ (c'est à dire sur la rangée d'adresse 68 dans la mémoire).

On notera que l'on choisit par convention des bits d'adresse actifs bas et un décodage d'adresse par portes NAND.

Le décodeur DECB₂ reçoit donc en entrée les bits a5-a7 du bus d'adresse interne ADR, pour reconnaître l'adresse 2. Il comprend un étage d'inversion 11, pour ici inverser le bit a6. En sortie dudit étage, on retrouve donc les bits a5, na6 et a7, appliqués en entrées d'une porte NAND 12 à deux sorties isolées comp₂ et comn₂. On a donc comp₂=comn₂=/(a5.na6.a7). Si c'est bien l'adresse du bloc B₂ qui est présente sur le bus de données, on aura donc ces deux signaux logiques mis à zéro. Si non, ils seront portés à 1. On notera que dans le cas qui nous intéresse particulièrement de circuits basse-tension, le niveau haut des signaux logiques correspond à la basse tension Vcc, par exemple de 3 volts.

La porte NAND à deux sorties isolées est explicitée en technologie CMOS sur la figure 4. L'isolation est obtenue de manière connue en intercalant un transistor d'isolation Tiso entre un réseau série RN de transistors N et un réseau parallèle RP de transistors P. Une sortie comn₂ est prise entre la sortie du réseau parallèle et le transistor d'isolation, l'autre sortie comp₂ est prise entre le transistor d'isolation et l'entrée du réseau série (la sortie comp2 est celle qui commande la commutation de la tension Vr, comme on le verra plus loin, d'où la nécessité de l'isolation entre les deux sorties).

Ces deux signaux comp₂ et comn₂ de validation de sélection du bloc B₂ sont appliqués aux circuits de commutation CM_{i,2} du bloc B₂, en particulier au circuit CM_{4,2}. Un inverseur 13 du signal comn₂ délivre en outre un signal VB₂ de validation du décodage des adresses de rangée.

Le décodeur DECr₄ de rangée d'adresse 4 du bloc B₂ comprend un premier circuit à étage d'inversion 14 et porte NAND 15 pour décoder l'adresse (4) de ce groupe. La porte NAND reçoit également en entrée le signal VB₂ de validation de décodage délivré par le décodeur du bloc associé DECB₂. La porte NAND est suivie d'un inverseur 16 qui délivre en sortie un signal sel₄,₂ de commande de sélection de rangée.

Un signal de commande de désélection dsel_{4'2} de la rangée d'adresse 4 du bloc B₂ est délivré directement par la sortie de la porte NAND.

Selon l'invention, le décodeur de rangée comprend en outre un circuit d'inhibition 17 recevant en entrée l'inverse du signal de filtrage f fourni par le circuit filtrage 7 selon l'invention et le signal de commande de sélection de rangée sel_{4,2}, pour fournir un signal de commande de sélection qui soit filtré selon le procédé de l'invention, noté fsel_{4,2}.

Ce circuit d'inhibition comprend dans l'exemple une première porte NAND 18 suivie en série par un inverseur 19.

Dans le décodeur décrit, si c'est la rangée 4 du bloc B₂ qui est effectivement adressée par le bus d'adresse interne ADR, le signal de commande de sélection sera au "1" logique, c'est à dire à environ 3 volts en basse-tension logique et le signal de commande de désélection dsel_{4'2} sera au "0" logique. Dans le cas contraire, c'est le signal dsel_{4'2} qui sera à "1" et le signal sel_{4,2} qui sera à "0".

Or, selon l'invention la détection d'un changement d'adresse sur le bus génère un signal f de filtrage. Le signal filtré de commande de sélection fsel_{4,2} en sortie du circuit 17 d'inhibition selon l'invention est donc forcé au niveau "0" logique pendant au moins une durée d1 sur détection d'un changement d'adresse, conformément au chronogramme de la figure 2. En fait, il est maintenu à zéro tant qu'il n'y a pas une adresse stable pendant une durée supérieure à d1. Ensuite, il prend le niveau logique du signal de commande de sélection sel_{4,2} : Si la rangée 4 du bloc B₂ est effectivement adressée, il passe donc au niveau logique "1".

C'est ce signal filtré de commande de sélection fsel_{4,2} qui est appliqué avec le signal de commande de désélection dsel_{4,2} au circuit CM_{4,2} de commutation de tension sur la rangée d'adresse 4 du bloc B₂, et associé au décodeur DECr₄. Ce circuit de commutation comprend dans l'exemple :
- un inverseur Cmos en série entre la tension Vr et la tension Vss, avec un transistor de type P noté Tp et un transistor de type N noté Tn, la grille du transistor Tn recevant le signal comp₂ délivré par le décodeur DECB₂ et la sortie de l'inverseur (aux drains des transistors Tp et Tn) étant connectée à la rangée à commander W_{4,2};
- un transistor de sélection de type N noté Ts, recevant sur sa grille le signal filtré de commande de sélection fsel_{4,2}, sa source étant connectée à la grille du transistor Tp et son drain recevant le signal comp₂ délivré par le décodeur DECB₂;
- un transistor de blocage de type P, noté Tb connecté entre la tension Vr et la grille du transistor Tp, ayant sa grille connectée à la sortie de l'inverseur;
- un transistor de désélection de type N, noté Tds, commandé sur sa grille par le signal de commande de désélection dsel_{4'2}, ayant sa source connectée à Vss et son drain connecté à la sortie de l'inverseur.

Dans ce circuit qui doit commuter la tension Vr sur la rangée si elle est sélectionnée ou la tension Vss si la rangée est désélectionnée, les signaux de commande comp_{2'} comn_{2'} sont actifs à l'état bas, noté "0" et correspondant à la tension logique nulle Vss et les signaux fsel_{4,2} et dsel_{4'2} sont actifs à l'état haut, noté "1" et correspondant à la haute tension logique , Vcc (3 volts dans l'exemple).

Le principe de fonctionnement est simple : quand le bloc 2 est adressé et si la rangée 4 est sélectionnée, les signaux de commande comn₂, comp₂ sont à "0" et le signal fsel_{4,2} est à "1". Le signal dsel_{4'2} est à "0".

Le signal comn₂ ("0") appliqué sur la grille du transistor Tn (qui a une tension de seuil positive) le bloque, tandis que le transistor de sélection Ts est rendu passant par le signal fsel_{4,2} ("1") : le transistor Tp de l'inverseur est donc passant et commute ainsi la tension Vr sur la rangée W_{4,2}.

Si la rangée 4 du bloc B₂ est désélectionnée, c'est le signal dsel_{4'2} qui devient actif ("1") et rend le transistor de désélection Tds conducteur, les transistors Ts et Tp étant eux bloqués. La rangée est alors portée à Vss.

Si le bloc n'est pas sélectionné, les signaux de commande comn₂, comp₂ sont tous deux à "1", le signal filtré de commande de sélection fsel_{4,2} est à "0" et le signal de commande de désélection dsel_{4'2} est à "1". En conséquence, les transistors Ts et Tp sont bloqués, tandis que les transistors Tn et Tds sont passant, ce qui a pour effet de maintenir (si la rangée était déjà désélectionnée) ou de porter (si la rangée était précédemment sélectionnée) la rangée désélectionnée à la masse.

Le transistor de blocage Tb est passant si la rangée est portée à la masse : il met ainsi la tension Vr sur la grille du transistor Tp, ce qui le maintient bloqué.

Comme on a vu plus haut que le signal filtré de commande de sélection fsel_{4,2} est maintenu à "0" par le circuit d'inhibition 17 tant qu'une adresse n'est pas stable au sens de l'invention (c'est à dire présente pendant au moins une durée d1), le transistor Tp est bloqué, empêchant tout appel de courant sur la ligne de tension Vr : Le multiplieur n'est donc pas sollicité tant qu'une adresse n'est pas stable sur le bus.

L'exemple de réalisation du décodeur que l'on vient d'expliciter en relation avec la figure 4 et plus généralement l'inhibition de la commande de sélection (sel_{4,2}) permet de ne retarder que la commutation de la tension Vr sur la rangée sélectionnée. En particulier, le décodage et la désélection ne sont pas retardés.

La durée déterminée d1 correspond à la durée maximale nécessaire au décodage de l'adresse, en sorte que le filtrage selon l'invention influe le moins possible sur le temps d'accès de la mémoire.

Le procédé de filtrage selon l'invention permet de rendre compatible le fonctionnement des mémoires asynchrones basse tension avec l'utilisation d'un multiplieur de tension interne, et son mode de réalisation préféré permet avantageusement de ne pas trop pénaliser le temps d'accès de la mémoire.

## Revendications

1. Procédé de décodage des adresses dans une mémoire organisée matriciellement en rangées et en colonnes et comprenant un multiplieur (6m) d'une tension d'alimentation Vcc du circuit pour fournir une tension de commande (Vr), le décodeur de rangée comprenant un circuit de décodage pour sélectionner une rangée adressée et désélectionner les autres rangées et un circuit de commutation de tension pour appliquer ladite tension de commande (Vr) sur la rangée sélectionnée et la masse sur les autres rangées déselectionnées, caractérisé en ce que une commande d'inhibition (f) est générée à chaque changement d'adresse détectée sur le bus d'adresse, la commande d'inhibition étant appliquée au circuit de commutation de tension pendant une durée déterminée correspondant au temps maximal nécessaire au circuit de décodage pour sélectionner une rangée adressée.

2. Mémoire en circuit intégré organisée matriciellement en rangées et en colonnes, et comprenant un multiplieur (6m) d'une tension d'alimentation Vcc du circuit pour fournir une tension de commande (Vr), un décodeur de rangée comprenant un circuit de décodage d'adresse pour sélectionner une rangée et désélectionner les autres et un circuit de commutation de tension pour appliquer ladite tension de commande (Vr) sur la rangée sélectionnée et la masse sur les autres rangées déselectionnées, caractérisé en ce que la mémoire comprend en outre un circuit détection de changement d'adresse (7) pour générer un signal de filtrage (f) pendant une durée déterminée, le décodeur de rangée comprenant en outre un circuit d'inhibition (17) recevant le signal de filtrage (f) pour inhiber le circuit de commutation de tension pour une durée déterminée correspondant au temps maximal nécessaire au circuit de décodage pour sélectionner une rangée adressée.

3. Mémoire en circuit intégré selon la revendication 2, le circuit de décodage d'adresse comprenant pour chaque rangée, un étage de décodage pour délivrer un signal de commande de sélection de la rangée et un signal de commande de désélection de la rangée et le circuit de commutation comprenant, pour chaque rangée, un étage de commutation pour commuter la tension de commande (Vr) ou la masse (Vss) sur la rangée selon l'état logique desdits signaux de commande, caractérisé en ce que le circuit de décodage comprend pour chaque étage de décodage un circuit d'inhibition (17) recevant le signal f de filtrage et le signal de commande de sélection de la rangée (sel_{4,2}) correspondant, pour délivrer en sortie un signal de commande de sélection de la rangée (fsel_{4,2}) filtré, appliqué avec le signal de commande de désélection correspondant (dsel_{4,2}) à l'étage de commutation.

4. Mémoire en circuit intégré selon la revendication 3, caractérisé en ce que le décodeur de rangée comprend pour chaque rangée un circuit d'inhibition (17) recevant en entrée le signal de filtrage (f) et un signal de commande de sélection de ladite rangée pour appliquer un signal filtré de commande de sélection (fsel_{4,2}) à un circuit de commutation d'une tension de sélection (Vr) sur ladite rangée.

5. Mémoire en circuit intégré selon l'une quelconque des revendications 3 à 4, caractérisée en ce que le circuit (7) de filtrage comprend un circuit (8) de détection de transitions d'adresse recevant en entrée les bits d'adresse (ai) et délivrant en sortie des signaux de détection de transition du bit correspondant (ati), une porte OU (9) recevant en entrée lesdits signaux de détection de transition (ati) pour délivrer un signal impulsionnel (Sd) de détection d'un changement d'adresse, et un circuit (10) générateur d'une impulsion recevant en entrée ledit signal impulsionnel de détection (Sd) et délivrant en sortie le signal de filtrage (f), pour émettre en sortie (f) une impulsion de durée égale à la durée déterminée (d1), en réponse à une impulsion sur le signal impulsionnel de détection.

## Patentansprüche

1. Verfahren zum Dekodieren von Adressen in einem matrixförmig in Zeilen und Spalten unterteilten Speicher mit einem Multiplizierer (6m) für eine Versorgungsspannung Vcc des Schaltkreises zum Ausgeben einer Steuerspannung (Vr), wobei der Zeilendekodierer einen Dekodierungsschaltkreis zum Auswählen einer adressierten Zeile und zum Nichtauswählen der anderen Zeilen und einen Spannungskommutatorschaltkreis zum Anlegen der Steuerspannung (Vr) an die ausgewählte Zeile und der Masse an die anderen nicht ausgewählten Zeilen umfaßt, dadurch gekennzeichnet, daß ein Inhibierungsbefehl (f) bei jeder erfaßten Adreßänderung auf dem Adreßbus erzeugt wird, wobei der Inhibierungsbefehl an den Spannungskommutatorschaltkreis während einer vorgegebenen Dauer angelegt wird, die der Zeit entspricht, die maximal für den Dekodierungsschaltkreis zum Auswählen einer adressierten Zeile notwendig ist.

2. Integrierter Speicherschaltkreis, der matrixförmig in Zeilen und Spalten unterteilt ist und einen Multiplizierer (6m) für eine Versorgungsspannung Vcc des Schaltkreises zum Ausgeben einer Steuerspannung (Vr), einen Zeilendekodierer mit einem Adreßdekodierungsschaltkreis zum Auswählen einer Zeile und zum Nichtauswählen der anderen und einen Spannungskommutatorschaltkreis zum Anlegen der Steuerspannung (Vr) an die ausgewählte Zeile und der Masse an die anderen nichtausgewählten Zeilen umfaßt, dadurch gekennzeichnet, daß der Speicher außerdem einen Schaltkreis zum Erfassen von Adreßänderungen (7) zum Erzeugen eines Filtersignals (f) während einer vorgegebenen Dauer umfaßt, wobei der Zeilendokodierer außerdem einen Inhibierungsschaltkreis (17) zum Inhibieren des Spannungskommutatorschaltkreises während einer vorgegebenen Dauer, die der Zeit entspricht, die maximal notwendig ist für den Dekodierungsschaltkreis, um eine adressierte Zeile auszuwählen, umfaßt.

3. Integrierter Speicherschaltkreis nach Anspruch 2, wobei der Schaltkreis zur Dekodierung der Adresse für jede Zeile eine Dekodierungsstufe zum Ausgeben eines Steuersignals zur Auswahl der Zeile und eines Steuersignals zur Nichtauswahl der Zeile umfaßt und der Kommutatorschaltkreis für jede Zeile eine Kommutatorstufe zum Kommutieren der Steuerspannung (Vr) oder der Masse (Vss) bei der Zeile je nach logischem Zustand der Steuersignale umfaßt, dadurch gekennzeichnet, daß der Schaltkreis zur Dekodierung für jede Dekodierungsstufe einen Inhibierungsschaltkreis (17) umfaßt, der das Filtersignal f und das Steuersignal zur Auswahl der entsprechenden Zeile (sel_{4,2}) empfängt, um am Ausgang ein gefiltertes Steuersignal zur Auswahl der Zeile (fsel_{4,2}) auszugeben, das mit dem entsprechenden Steuersignal zur Nichtauswahl (dsel_{4,2}) an die Kommutatorstufe angelegt wird.

4. Integrierter Speicherschaltkreis nach Anspruch 3, dadurch gekennzeichnet, daß der Zeilendekodierer für jede Zeile einen Inhibierungsschaltkreis (17) umfaßt, der am Eingang das Filtersignal (f) und ein Steuersignal zur Auswahl der Zeile empfängt, um ein gefiltertes Steuersignal zur Auswahl (fsel_{4,2}) an einen Schaltkreis zur Kommutierung einer Auswahlspannung (Vr) bei der Zeile auszugeben.

5. Integrierter Speicherschaltkreis nach einem der Ansprüche 3 oder 4, dadurch gekennzeichnet, daß der Schaltkreis (7) zur Filterung einen Schaltkreis (8) zur Erfassung von Adreßübergängen aufweist, der am Eingang die Adreßbits (ai) empfängt und am Ausgang Erfassungsignale zum entsprechenden Bitübergang (ati) ausgibt, wobei ein ODER-Gatter (9) am Eingang die Übergangserfassungssignale (ati) empfängt, um ein Impulssignal (Sd) der Erfassung einer Adreßänderung auszugeben, und ein Impulsgeneratorschaltkreis (10) am Eingang das Erfassungsimpulssignal (Sd) empfängt und am Ausgang das Filtersignal (f) ausgibt, um am Ausgang (f) einen Impuls mit derselben Dauer wie die vorgegebene Dauer (d1) auf einen Impuls auf das Erfassungsimpulssignal abzugeben.

## Claims

1. A method for decoding addresses in a memory organised as a matrix into rows and into columns and comprising a multiplier (6m) for a supply voltage Vcc of the circuit to provide a control voltage (Vr), the row decoder comprising a decoding circuit for selecting an addressed row and for deselecting the other rows and a voltage switching circuit for applying the said control voltage (Vr) to the selected row and the earth to the other deselected rows,
**characterised in that** a disabling command (f) is generated at each change of address detected on the address bus, the disabling command being applied to the voltage switching circuit for a determined period corresponding to the maximum time necessary for the decoding circuit to select an addressed row.

2. A memory as an integrated circuit organised as a matrix into rows and into columns, and comprising a multiplier (6m) for a supply voltage Vcc of the circuit for supplying a control voltage (Vr), a row decoder comprising an address decoding circuit for selecting a row and for deselecting the others and a voltage switching circuit for applying the said control voltage (Vr) to the selected row and the earth to the other deselected rows,
**characterised in that** the memory also comprises an address changing detection circuit (7) for generating a filtering signal (f) for a determined period, the row decoder also comprising a disabling circuit (17) receiving the filtering signal (f) for disabling the voltage switching circuit for a determined duration corresponding to the maximum time necessary for the decoding circuit to select an addressed row.

3. A memory as an integrated circuit according to Claim 2, the address decoding circuit comprising for each row a decoding stage for supplying a control signal for selecting the row and a control signal for deselecting the row and the switching circuit comprising, for each row, a switching stage for switching the control voltage (Vr) or the earth (Vss) to the row according to the logic state of the said control signals,
**characterised in that** the decoding circuit comprises for each decoding stage a disabling circuit (17) receiving the filtering signal f and the corresponding control signal for selecting the row (sel_{4,2}), to supply at the output a filtered control signal for selecting the row (fsel_{4,2}), applied with the corresponding deselection control signal (dsel_{4,2}) to the switching stage.

4. A memory as an integrated circuit according to Claims 3, **characterised in that** the row decoder comprises for each row a disabling circuit (17) receiving at the output the filtering signal (f) and a control signal for selecting the said row to apply a filtered selection control signal (fsel_{4,2}) to a circuit for switching a selection voltage (Vr) to the said row.

5. A memory as an integrated circuit according to any one of Claims 3 to 4,
**characterised in that** the filtering circuit (7) comprises a circuit (8) for detecting address transitions receiving at the output the address bits (ai) and supplying at the output signals detecting the transition of the corresponding bit (ati), an OR gate (9) receiving at the input the said transition detection signals (ati) for supplying a pulsed signal (Sd) for detecting a change of address, and a pulse generating circuit (10) receiving at the input the said pulsed detection signal (Sd) and supplying at the output the filtering signal (f), for emitting at the output (f) a pulse having a duration equal to the determined duration (dl), in response to a pulse on the pulsed detection signal.
